# EUROPÄISCHE PATENTSCHRIFT

(11) **EP 1 734 253 B1**
(45) Veröffentlichungstag und Bekanntmachung des Hinweises auf die Patenterteilung: **19.03.2008**
(21) Anmeldenummer: 05013169.7
(22) Anmeldetag: 17.06.2005
(51) Int. Cl.: F02M 61/16, F02M 51/06, H01L 41/053

(54) **Einspritzventil mit einem Gehäuse und Verfahren zur Herstellung eines Gehäuses**
Injection valve with housing and method for producing said housing
Soupape d'injection avec manchon et méthode de sa production

(43) Veröffentlichungstag der Anmeldung: 20.12.2006
(73) Patentinhaber: SIEMENS AKTIENGESELLSCHAFT, 80333 München (DE)
(72) Erfinder: Freudenberg, Hellmut, 93080 Grossberg (DE); Hamann, Christoph, Dr., 93107 Thalmassing (DE); Lewentz, Günter, 93093 Donaustauf (DE); Weisse, Manfred, 90489 Nürnberg (DE)

(56) Entgegenhaltungen:
- EP-A- 1 391 607
- WO-A-03/016707
- DE-A1- 1 815 260
- DE-A1- 10 315 067

## Beschreibung

Die Erfindung betrifft eine Einspritzventil mit einem Gehäuse gemäß dem Oberbegriff des Patentanspruchs 1 und ein Verfahren zur Herstellung eines Gehäuses für ein Einspritzventil gemäß Patentanspruch 9.

Einspritzventile, insbesondere Einspritzventile für Dieselkraftstoff mit einem piezoelektrischen Aktor müssen verschiedenste Randbedingungen erfüllen. Das Gehäuse des Einspritzventils muss beispielsweise in Bezug auf die thermische Ausdehnung des piezoelektrischen Aktors angepasst sein, damit keine Fehlstellung des piezoelektrischen Aktors bei Temperaturänderungen auftritt. Zudem soll die Herstellung des Gehäuses kostengünstig sein.

Aus dem Stand der Technik ist es bekannt, das Aktorgehäuse aus Invar, Pernifer 36 o. ä. auszubilden, das einen ähnlichen thermischen Ausdehnungskoeffizienten wie der piezoelektrische Aktor aufweist. Legierungen dieser Art sind jedoch technisch aufwändig zu bearbeiten. Deshalb wird das Gehäuse des Einspritzventils aus Stahl hergestellt und der Aktor mit dem Aktorgehäuse auf das Gehäuse des Einspritzventils aufgesetzt. Somit ist der gesamte Aufbau des Einspritzventils relativ lang.

Aus WO 03/016707 A ist eine Dosiervorrichtung bekannt, die einen inneren Injektorkörper aufweist, der einen Injektorantrieb aufnimmt. Eine Hülle umschließt den inneren Injektorkörper mindestens teilweise radial, sodass zwischen beiden ein umlaufendes spaltförmiges Speichervolumen gebildet wird, das in gedrosselter fluidischer Verbindung mit einer Einspritzdüse und einem Kraftstoffanschluss steht, insbesondere geeignet als Benzin-Direkteinspritzer zur Reduzierung von Druckschwankungen beim Öffnungsvorgang. Ein innerer Injektorkörper ist im Querschnitt ringförmig ausgebildet und von einer Hülle in Form eines zylindrischen Rohres umschlossen.

Aus EP-A-1 391 607 ist ein Einspritzventil für eine Benzindirekteinspritzung bekannt, wobei das Einspritzventil ein Gehäuse aufweist, das ein äußeres, rohrförmiges Bauteil und ein inneres rohrförmiges Bauteil aufweist. Das äußere rohrförmige Bauteil bildet eine äußere Hülle des Einspritzventils. Das innere rohrförmige Bauteil enthält einen piezoelektrischen Aktor. Zwischen dem äußeren rohrförmigen Bauteil und dem inneren rohrförmigen Bauteil wird ein ringförmiger Transportkanal für den Kraftstoff ausgebildet.

Aus DE 18 15 260 A1 ist ein Kraftstoffventil bekannt, das durch folgende Verfahrensschritte hergestellt ist: Zwei mindestens annähernd gleich breite Stahlbänder, deren sich berührende Seiten verkupfert sind, wobei bei einer dieser Seiten mindestens eine Längsnut als Kraftstofflängskanal eingearbeitet ist, werden zu einem Rohr geformt und an der Längsnahtstelle verschweißt. Auf diese Weise wird ein Rohr gefertigt, das in entsprechend lange Stücke abgetrennt wird, wobei bei beiden Enden die Rohrwände zum Abdichten des Längskanals gegeneinander gewalzt werden und durch einen hartlötenden Ventilkörper hergestellt werden. Das hergestellte Kraftstoffeinspritzventil weist einen schafftförmigen Ventilkörper auf, wobei die zwei koaxial zueinander angeordneten und dabei mindestens einen Kraftstofflängskanal einschließenden Rohrwände an den Enden abgedichtet sind und einen Zuflusskanal und einen Abflusskanal aufweisen.

Eine Aufgabe der Erfindung besteht darin, ein Einspritzventil mit einem kostengünstigen Gehäuse und ein kostengünstiges Verfahren zur Herstellung eines Gehäuses für ein Einspritzventil bereitzustellen.

Die Aufgabe der Erfindung wird durch das Einspritzventil mit den Merkmalen des Anspruchs 1 und mit dem Verfahren mit den Merkmalen des Anspruchs 9 gelöst.

Vorteilhafte Weiterbildungen des Einspritzventils und des Verfahrens sind in den abhängigen Ansprüchen angegeben.

Ein Vorteil des Einspritzventils gemäß Anspruch 1 besteht darin, dass das Gehäuse für das Einspritzventil aus einem Material gefertigt werden kann, das eine hohe Zähigkeit aufweist und schwer zu spanen ist. Zudem kann das Gehäuse kostengünstig hergestellt werden, da auf spanende Verfahren zur Einbringung eines Aktorraums in das Gehäuse auf ein Minimum reduziert werden können. Dies wird dadurch erreicht, dass das Gehäuse aus einer längsgeschlitzten Hülse gefertigt ist, dass entlang des Schlitzes zwei Kanten gegenüberliegend angeordnet sind und dass die Kanten des Längsschlitzes der Hülse mit einer Verbindungsnaht verbunden sind. Auf diese Weise ist es nicht erforderlich, einen Aktorraum in ein Vollmaterial einzubringen, sondern das Gehäuse wird in Form einer Hülse gerollt und z. B. verschweißt. Erfindungsgemäß ist durch den Formprozess eine Kontur eines Aktorraums in ein Profilstück eingebracht. Mit einem anschließenden Biegeverfahren, vorzugsweise über einen Dorn mit entsprechender Geometrie, wird das Profilstück mit der Ausnehmung in eine Hülsenform gebogen, wobei gegenüberliegende Längskanten miteinander verbunden sind. Auf diese Weise ist es möglich, ein Gehäuse in Form einer Hülse mit einer Kante eines Aktorraums auszubilden. Die verwendeten Formungsverfahren ermöglichen es, eine Kontur des Aktorraums auszubilden, ohne ein spanendes oder elektroerosives Verfahren zu benötigen

In einer einfachen Ausführungsform ist die geschlitzte Hülse aus einer gebogenen Platte hergestellt. Weiterhin ist es vorteilhaft, dass die Hülse aus einem geformten, insbesondere gewalzten oder stranggepressten Material gefertigt ist.

In einer weiteren Ausbildungsform wird das Gehäuse aus einem im Querschnitt U-förmig geformten Profilstück mit einer offenen Längsseite hergestellt, wobei die offene Längsseite mit einer Abdeckung bedeckt ist, die mit dem Profilstück verbunden ist. Auch diese Herstellungsart ist kostengünstig, einfach auszuführen und als Material kann ein zähes Material verwendet werden, das schwer zu spanen ist.

In einer weiteren Ausführungsform ist das Gehäuse des Einspritzventils aus einem vorgeformten Profilstück mit einem U-Profil im Querschnitt gebildet, wobei ein erster Schenkel des U-Profils länger als ein zweiter Schenkel ausgebildet ist. Der längere Schenkel wird entlang einer Längsachse des Profilstücks umgebogen und auf eine Längskante des kürzeren Schenkels gelegt. Die zwei Schenkel werden im Bereich der Längskante form- oder kraftschlüssig zusammengehalten. Auch diese Ausbildungsform ist einfach und kostengünstig herzustellen, wobei ein geformtes Profilstück zur Ausbildung der Hülse verwendet wird.

In einer weiteren Ausbildungsform weist das Gehäuse des Einspritzventils eine untere Platte auf, wobei die untere Platte im Wesentlichen senkrecht zur Längsachse der Hülse angeordnet ist. Die untere Platte weist ein Außengewinde auf, mit dem eine Spannmutter verschraubt ist. Die Spannmutter dient zum Vorspannen einer Einspritzdüse gegen die untere Platte. Diese Ausbildungsform bietet trotz der Ausbildung des Gehäuses in Form einer Hülse sowohl eine Anlagefläche für die Einspritzdüse als auch ein Gewinde zum Festschrauben der Spannmutter.

In einer weiteren Ausführungsform weist das Gehäuse eine obere, kreisförmige Platte auf, die mit einem oberen Ende der Hülse befestigt ist. Um die obere kreisförmige Platte ist eine Spannhülse geschoben, die mit einem unteren Randbereich gegen die Einspritzdüse abgestützt ist. Zudem weist die Spannhülse im oberen Endbereich eine Auflagefläche für ein Spannmittel auf. Damit kann das Gehäuse trotz der Hülsenform mithilfe einer Spannhülse und einer Spannpratze als Spannmittel gegen einen Dichtsitz im Zylinderkopf vorgespannt werden.

In einer bevorzugten Ausführungsform ist der Aktorraum im Querschnitt in Form eines abgerundeten Viereckes ausgebildet. Dadurch weist der Aktorraum im Wesentlichen den Querschnitt des piezoelektrischen Aktors auf. Damit ist der piezoelektrische Aktor präzise im Gehäuse des Einspritzventils geführt. Damit kann auf eine Ummantelung des Aktors verzichtet werden und der Aktor kann in seiner im Querschnitt quadratischen Form direkt in das Gehäuse eingebaut werden.

Das erfindungsgemäße Verfahren nach Anspruch 9 weist den Vorteil auf, dass ein Gehäuse eines Einspritzventils zur Aufnahme eines piezoelektrischen Aktors mithilfe eines einfachen Verfahrens hergestellt werden kann, bei dem ein Material für das Gehäuse verwendet werden kann, das schwer zu spanen ist. Dies wird dadurch erreicht, dass eine Ausnehmung, die eine Kontur des Aktorraumes aufweist, in ein formbares Material eingebracht wird und ein Profilstück erhalten wird. Anschlie-ßend wird über einen Biegeprozess aus einem länglichen Profilstück ein hülsenförmiges Gehäuse mit einer Verbindungsnaht hergestellt. Aufgrund des beschriebenen Verfahrens werden spanende oder räumende Verfahren zur Ausbildung des Aktorraums auf das Nötigste beschränkt. Somit steht eine größere Anzahl von Materialien zur Ausbildung des Gehäuses zur Verfügung. Insbesondere können auch zähe Materialien, die einen thermischen Ausdehnungskoeffizienten entsprechend dem piezoelektrischen Aktor aufweisen, verwendet werden.

Als vorteilhaft zur Ausbildung der Ausnehmung haben sich Walzverfahren, Rollverfahren oder Strangpressverfahren gezeigt.

In einer weiteren Ausbildungsform wird das Gehäuse mit einem geformten Profilstück hergestellt, das entlang einer Längsseite offen ist. Die offene Längsseite des Profilstücks wird mit einer Abdeckung abgedeckt, die in Randbereichen mit Längskanten des Profilstückes verbunden wird. Die Abdeckung ist aus dem gleichen Material wie das Profilstück gefertigt.

Auch mit diesem Verfahren ist es möglich, ein Gehäuse für ein Einspritzventil herzustellen, bei dem weitgehend auf spanende Verfahren verzichtet werden kann.

In einer weiteren Ausbildungsform ist das Gehäuse aus einem Profilstück mit einem U-Profil im Querschnitt ausgebildet. Ein erster Schenkel des U-Profils ist länger als ein zweiter Schenkel. Der längere Schenkel wird entlang einer Längsachse umgebogen und auf eine Längskante des kürzeren Schenkel gelegt, so dass die zwei Schenkel im Bereich der Längskanten form- und/oder kraftschlüssig zusammen gehalten werden. Auch bei diesem Verfahren kann auf spanende Bearbeitungsverfahren verzichtet werden.

Die Erfindung wird im Folgenden anhand der Figuren näher erläutert. Es zeigen:
- Fig. 1: eine schematische Darstellung eines Einspritzventils,
- Fig. 2: eine erste Ausführungsform eines Profilstücks,
- Fig. 3: einen Querschnitt durch eine erste Ausführungsform einer Hülse,
- Fig. 4: eine zweite Ausführungsform eines Profilstücks mit einer Abdeckung,
- Fig. 5: einen Querschnitt durch eine zweite Hülse,
- Fig. 6: einen Querschnitt durch ein drittes Profilstück,
- Fig. 7: einen Querschnitt durch eine dritte Ausführungsform einer Hülse,
- Fig. 8: einen Querschnitt durch ein Gehäuse,
- Fig. 9: einen Querschnitt durch eine weitere Ausführungsform eines Einspritzventils,
- Fig. 10: einen Querschnitt eines weiteren Profilstücks,
- Fig. 11: einen Querschnitt durch das weitere Profilstück mit eingelegtem Dorn, und
- Fig. 12: eine Hülse mit einem Verschluss-Stopfen.

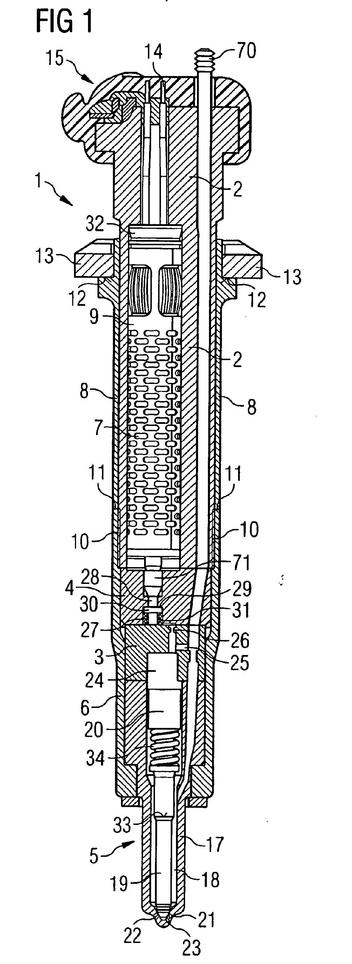

Figur 1 zeigt in einem schematischen Querschnitt ein Einspritzventil in Form eines Cammon-Rail-Injektors. Das Einspritzventil 1 weist ein Gehäuse 2 mit einem Aktorraum 9 auf, in dem ein Aktor 7 angeordnet ist. Der Aktor 7 ist als piezoelektrischer Aktor ausgebildet, der über eine Spannhülse gegen eine Auslenkung vorgespannt ist. Weiterhin ist anliegend an ein unteres Ende des Gehäuses 2 eine Ventilplatte 4 vorgesehen, an deren Unterseite wiederum eine Drosselplatte 3 angeordnet ist. An der Unterseite der Drosselplatte 3 ist eine Einspritzdüse 5 angeordnet. Die Einspritzdüse 5 wird über eine Spannmutter 6 gegen die Drosselplatte 3 in Richtung auf das Gehäuse 2 vorgespannt. Dazu ist die Spannmutter 6 über ein erstes Gewinde 10 mit dem Gehäuse 2 oberhalb der Ventilplatte 4 verschraubt. Die Spannmutter 6 weist einen oberen Randbereich 11 auf, an dem ein unterer Randbereich einer Spannhülse 8 anliegt. Die Spannhülse 8 umgibt das Gehäuse 2 und erstreckt sich bis in einen oberen Bereich, der im Bereich des oberen Endes des Aktors 7 angeordnet ist. Im oberen Bereich weist die Spannhülse 8 eine Auflagefläche 12 zur Auflage einer Spannpratze 13 auf. Elektrische Anschlüsse 14 des piezoelektrischen Aktors 7 sind nach oben bis in einen Steckerbereich 15 geführt. Das Gehäuse 2 weist eine Kraftstoffbohrung 16 auf, die ausgehend von einem Anschluss 70 durch das Gehäuse 2, durch die Ventilplatte 4, durch die Drosselplatte 3 bis in einen Druckraum 18 des Düsenkörpers 17 geführt ist. Im Düsenkörper 17 ist eine Einspritznadel 19 beweglich angeordnet, die in einen oberen Endbereich einen Nadelkolben 20 aufweist, der dichtend im Düsenkörper 17 geführt ist. Unterhalb des Nadelkolbens 20 ist zwischen dem Düsenkörper 17 und der Einspritznadel 19 der Druckraum 18 ausgebildet. Am unteren Ende weist die Einspritznadel 19 eine Dichtfläche 21 auf, die einem Dichtsitz 22, der auf der Innenseite des Düsenkörpers 17 ausgebildet ist, zugeordnet ist. Unterhalb des Dichtsitzes 22 ist ein Einspritzloch 23 im Düsenkörper 17 ausgebildet. Oberhalb des Nadelkolbens 20 ist ein Steuerraum 24 zwischen der Drosselplatte 3, dem Düsenkörper 17 und dem Nadelkolben 20 ausgebildet. Der Steuerraum 24 ist über eine Zulaufdrossel 25 mit der Kraftstoffbohrung 16 verbunden. Der Steuerraum 24 ist über eine Ablaufdrossel 26 mit einem Ventilraum 27 verbunden, der in der Ventilplatte 4 ausgebildet ist. Der Ventilraum 27 weist eine Abflussöffnung 28 auf, die von einem ringförmigen zweiten Dichtsitz 29 umgeben und mit einem Niederdruckbereich verbunden ist. Im Ventilraum 27 ist ein Servoventil mit einem Schließglied 30 angeordnet, das eine zweite Dichtfläche aufweist, die dem zweiten Dichtsitz 29 zugeordnet ist. Das Schließglied 30 wird von einer Vorspannfeder 31 gegen den zweiten Dichtsitz 29 vorgespannt.

Der Aktor 7 weist einen Kolben 71 auf, der ausgehend von dem Aktorraum 9 durch die Abflussöffnung 28 zum Schließglied 30 geführt ist. Zudem ist der Aktor 7 am gegenüberliegenden Ende in einem Anschlussbereich 32 fest mit dem Gehäuse 2 verbunden.

Die Einspritznadel 19 weist eine Druckfläche 33 auf, an der der Kraftstoffdruck im Druckraum 18 angreift. Der angreifende Kraftstoffdruck versucht die Einspritznadel 19 entgegen einer Vorspannkraft einer Nadelfeder 34 vom Dichtsitz 22 abzuheben. Die Nadelfeder 34 ist zwischen dem Düsenkörper 17 und die Einspritznadel 19 eingespannt.

Der Druck im Steuerraum 24 drückt die Einspritznadel 19 gegen den Dichtsitz 22. Der Steuerraum 24 wird über die Zulaufdrossel 25 mit Kraftstoff versorgt. In Abhängigkeit davon, ob der piezoelektrische Aktor 7 das Schließglied 30 vom zweiten Dichtsitz 29 abhebt oder nicht, ist das Servoventil und damit die Abflussöffnung 28 geöffnet. Bei geöffneter Abflussöffnung 28 fließt mehr Kraftstoff über die Ablaufdrossel 26 ab, als über die Zulaufdrossel 25 zufließt. Somit sinkt der Druck im Steuerraum 24 und die Einspritznadel 29 wird durch den Druck im Druckraum 18 vom Dichtsitz 22 abgehoben. Wird das Servoventil wieder geschlossen, so steigt der Druck im Steuerraum 24 und die Einspritznadel 19 wird wieder auf den Dichtsitz 22 gedrückt.

Das Gehäuse 2 weist im Wesentlichen die Form einer einseitig offenen, vorzugsweise zylinderförmigen Hülse auf, wobei in der Hülse der Aktorraum 9 ausgebildet ist.

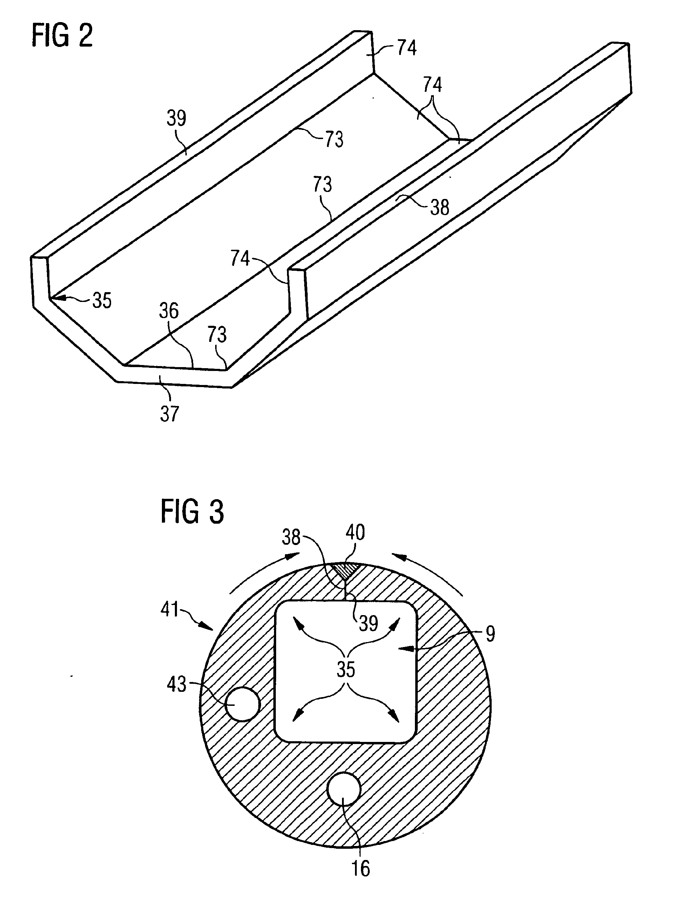

Figur 2 zeigt einen Querschnitt durch eine erste Ausbildungsform eines Profilstücks 37. Das Gehäuse 2 wird aus einem formbaren Profilstück hergestellt. Das Profilstück 37 wurde aus einer Platte oder Stange geformt, wobei mit einem Formverfahren eine Kontur 35 in eine Oberseite 36 des Profilstückes 37 eingeprägt wurde. Die Kontur 35 stellt eine offene Form eines Aktorraums 9 dar, der durch einen folgenden Biegeprozess hergestellt wird. Beispielsweise weist die Kontur 35 abgerundete Längsecken 73 und Seitenflächen 74 des zu bildenden Aktorraums 9 auf. Anschließend wird in einem Biegeprozess das Profilstück 37 um eine Längsachse gebogen, wobei zwei Längskanten 38, 39 aufeinander zubewegt werden. Zudem werden die Seitenflächen 74 aufeinander zugebogen, wobei die Längsecken 73 Biegeachsen für die Seitenflächen 74 darstellen. Dann werden die Längskanten 38, 39 über eine Schweißnaht 40 miteinander verbunden.

Figur 3 zeigt eine entsprechend hergestellte Hülse 41 im Querschnitt. Zudem wird in die Hülse 41 noch eine Kraftstoffbohrung 16, eine Leckagebohrung 43, Fixierstiftbohrungen und Verbindungsnuten eingebracht. Die Kontur 35 begrenzt den Aktorraum 9.

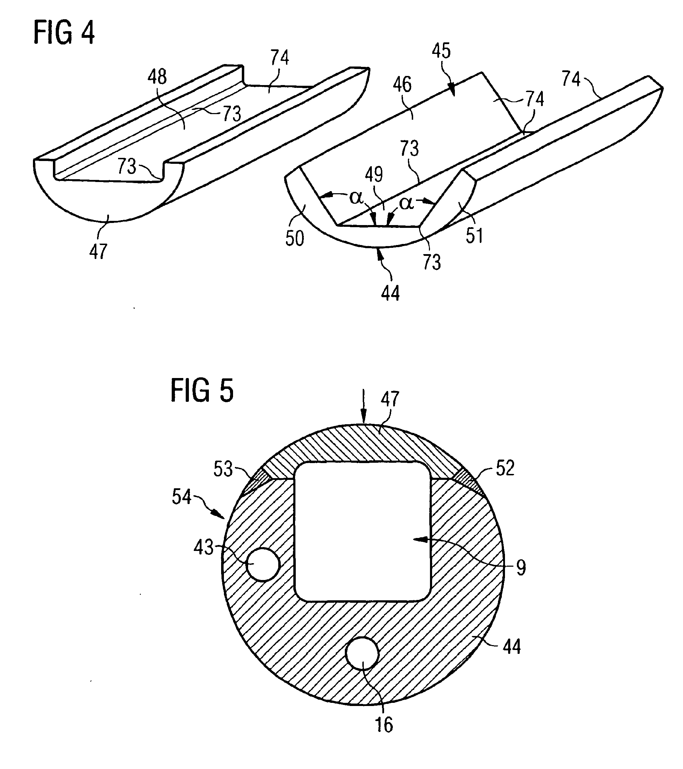

Figur 4 zeigt ein weiteres Profilstück 44, das über einen Formprozess hergestellt wird. Beispielsweise kann das weitere Profilstück 44 aus einem Rundstab gefertigt werden, in den eine Nut eingefräst wird, die eine zweite Kontur 45 darstellt. In das weitere Profilstück 44 wurde mit einem formgebenden Verfahren die zweite Kontur 45 mit einer zweiten Oberfläche 46 eingearbeitet. Zudem wird mit formgebenden Verfahren ein Abdeckteil 47 hergestellt, das ebenfalls in Figur 4 dargestellt ist. Das Abdeckteil 47 weist eine Teilkontur 48 auf einer Oberfläche auf, die ebenfalls über formende Verfahren eingebracht wird. Die zweite Kontur 45 und die Teilkontur 48 stellen Seitenflächen 74 eines zu bildenden Aktorraums 9 dar.

Das zweite Profilstück 44 weist im Wesentlichen im Querschnitt eine offene U-Form mit annähernd gleich langen Schenkeln 50, 51 auf. Die Schenkel 50, 51 sind über eine Verbindungsplatte 49 miteinander verbunden. Die Schenkel 50, 51 weisen zu einer Innenseite der Verbindungsplatte 49 einen Winkel auf, der größer als 90° ist. Zwischen den zwei Schenkeln 50, 51 und der Verbindungsplatte 49 sind Längsecken 73 ausgebildet.

Das Abdeckteil 47 weist ebenfalls im Querschnitt eine U-Form mit zwei kurzen Schenkel auf. Die Teilkontur 48 entspricht im Wesentlichen einer Seitenfläche einer im Querschnitt abgerundeten Viereckform eines Aktorraums 9. In einem weiteren Biegeprozess werden der erste und der zweite Schenkel 50, 51 des zweiten Profilstückes 44 zusammengedrückt, bis im Wesentlichen der Winkel α zwischen dem ersten Schenkel 50 und der Verbindungsplatte 49 bzw. zwischen dem zweiten Schenkel 51 und der Verbindungsplatte 49 annähernd 90° erreicht. Anschließend wird das Abdeckteil 47 mit den kurzen Schenkeln auf die Schenkel 50, 51 des zweiten Profilstückes 44 aufgelegt. Die kurzen Schenkel des Abdeckteils 47 werden mit den Schenkeln 50, 51 des zweiten Profilstückes 44 über zweite und dritte Schweißnähte 52, 53 verbunden. Auf diese Weise wird eine zweite Hülse 54 hergestellt, das im Querschnitt in Figur 5 dargestellt ist. Die zweite Hülse 54 umfasst den Aktorraum 9. Zudem sind in das zweite Profilstück 44 eine Kraftstoffbohrung 16, eine Leckagebohrung 43, eine Fixierstiftbohrung und Verbindungsnuten eingebracht.

In einer einfachen Ausführungsform kann das Abdeckteil 47 als Platte mit einer planen Seite ausgebildet sein, die beim Verbinden mit dem zweiten Profilstück 44 auf die Schenkel 50, 51 des zweiten Profilstücks 44 aufgelegt wird. Das Abdeckteil 47 und das zweite Profilstück 44 bestehen aus dem gleichen Material.

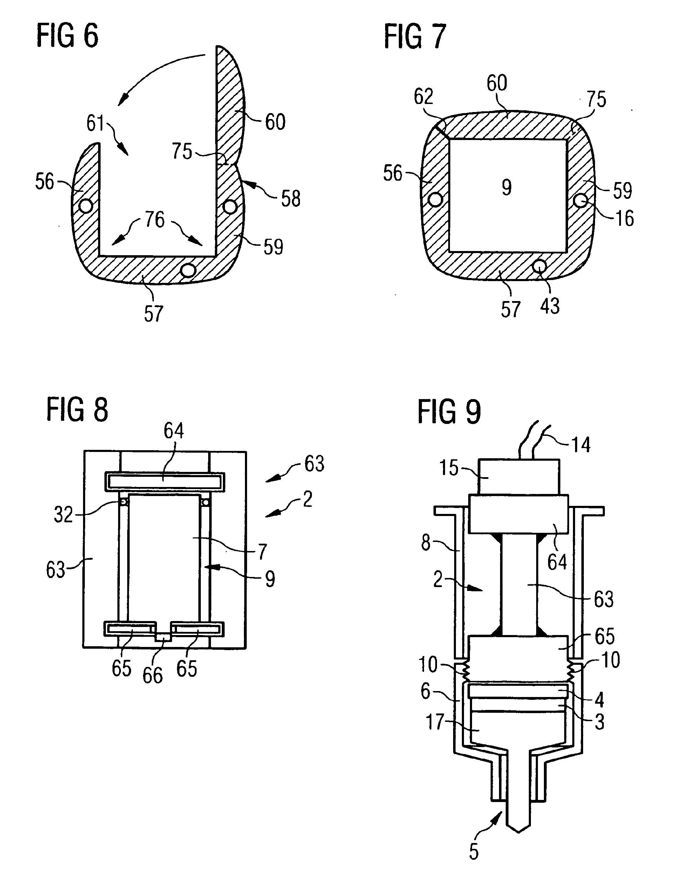

Figur 6 zeigt im Querschnitt ein drittes Profilstück 55, das im Wesentlichen im Querschnitt eine U-Form mit unterschiedlich langen Schenkeln aufweist. Ein kurzer Schenkel 56 ist über eine zweite Verbindungsplatte 57 mit einem langen Schenkel 58 verbunden. Der lange Schenkel 58 weist eine Biegelinie 75 auf, die parallel zur Längsachse des dritten Profilstücks 55 ausgebildet ist und den langen Schenkel 58 in einen ersten Schenkelabschnitt 59 und in einen zweiten Schenklabschnitt 60 unterteilt. Der erste Schenkelabschnitt 59 weist im Wesentlichen die gleiche Länge, wie der kurze Schenkel 56 auf. Das dritte Profilstück 55 ist mithilfe eines Formgebungsverfahrens hergestellt, wobei als Formgebungsverfahren Walzen, Rollen oder Strangpressen und Biegen verwendet werden. Das dritte Profilstück 55 weist auf einer Innenseite 61 eine dritte Kontur 76 auf, die mithilfe des Formgebungsverfahrens in das dritte Profilstück 55 eingebracht wurde. Die dritte Kontur 76 stellt Seitenflächen 74 und Längsecken eines Aktorraums 9 dar. In einem weiteren Verfahrensschritt wird der zweite Schenkelabschnitt 60 entlang der Biegelinie 75 in Richtung auf den kurzen Schenkel 56 gebogen und die Schenkelenden des kurzen Schenkels 56 und des langen Schenkels 58 werden über eine vierte Schweißnaht 62 miteinander verbunden.

Figur 7 zeigt einen Querschnitt durch eine dritte Hülse 63, die gemäß dem Verfahren nach Figur 6 hergestellt wurde und eine Kraftstoffbohrung 16 und eine Leckagebohrung 43 aufweist.

Die dritte Hülse 63 wird mit einer oberen Abdeckplatte 64 versehen, so dass ein einseitig offener Aktorraum 9 erhalten wird, wie in Figur 8 dargestellt ist. In den Aktorraum 9 wird der piezoelektrische Aktor 7 eingesteckt und in einem Anschlussbereich 32 mit einem oberen Ende fest mit der oberen Abdeckplatte 64 verbunden. Anschließend wird eine untere Abdeckplatte 65 mit der dritten Hülse 63 verbunden, wobei die untere Abdeckplatte 65 eine Öffnung 66 zum Durchführen des Kolbens 71 des Aktors 7 aufweist. Die dritte Hülse 63 mit der oberen und der unteren Abdeckplatte 64, 65 stellt ein Gehäuse 2 für ein Einspritzventil 1 dar.

Zur Befestigung der dritten Hülse 63 mit der oberen und/oder mit der unteren Abdeckplatte 64, 65 können verschiedene Herstellungsverfahren, insbesondere das Davex-Herstellungsverfahren verwendet werden. Beispielsweise kann die obere Abdeckplatte 64 auch über eine Schweißnaht mit der dritten Hülse 63 verbunden sein. Weiterhin kann die untere Abdeckplatte 65 über die Spannmutter 6 gegen die dritte Hülse 63 vorgespannt sein. Zudem kann die untere Abdeckplatte 65 über eine Schweißnaht mit der dritten Hülse 63 verbunden sein.

Abhängig von der Ausführungsform weisen die obere und die untere Abdeckplatte 64, 65 im Wesentlichen den gleichen Querschnitt, wie die dritte Hülse 63 auf. Vorzugsweise sind die obere und untere Abdeckplatte 64, 65 kreisförmig ausgebildet.

Es kann jedoch vorteilhaft sein, den Querschnitt der dritten Hülse 63 kleiner auszubilden, als den Querschnitt der oberen und der unteren Abdeckplatte 64, 65. Eine entsprechende Ausführungsform ist in Figur 9 dargestellt. In Figur 9 ist die dritte Hülse über Schweißnähte mit der oberen und der unteren Abdeckplatte 64, 65 verbunden. Zudem ist an der unteren Abdeckplatte 65 ein Schraubgewinde 10 angebracht, über das die Spannmutter 6 mit der unteren Abdeckplatte 65 verschraubt ist. Die Spannmutter 6 drückt in dieser Ausführungsform den Düsenkörper 17, die Drosselplatte 3 und die Ventilplatte 4 gegen die untere Abdeckplatte 65. Dabei ist die Öffnung 66 der unteren Abdeckplatte 65 auf die Abflussöffnung 28 in der Weise ausgerichtet, dass der Aktorkolben durch die Öffnung 66 in die Abflussöffnung 28 ragt.

Zur Ausbildung der Profilstücke können Materialien verwendet werden, die einen Ausdehnungskoeffizienten entsprechend dem piezoelektrischen Aktor aufweisen. Dazu eignen sich Eisen-Nickel-Legierungen, wie z. B. Pernifer 36 oder Invar. In vorteilhafter Weise können für die Ausbildung der Hülsen des Gehäuses 2 Materialien verwendet werden, die aufgrund des thermischen Ausdehnungskoeffizienten sehr gut zu dem thermischen Ausdehnungskoeffizienten des piezoelektrischen Aktors passen, die aber schwer mit spanenden oder räumenden Verfahren bearbeitet werden können.

In einer einfachen Ausführungsform kann die Hülse in Form einer gebogenen dünnen Platte ausgebildet sein, die zwischen der unteren und der oberen Abdeckplatte 65, 64 angeordnet ist und über eine Schweißnaht mit der untern und der oberen Abdeckplatte 65, 64 verbunden ist, wie in Figur 9 dargestellt ist.

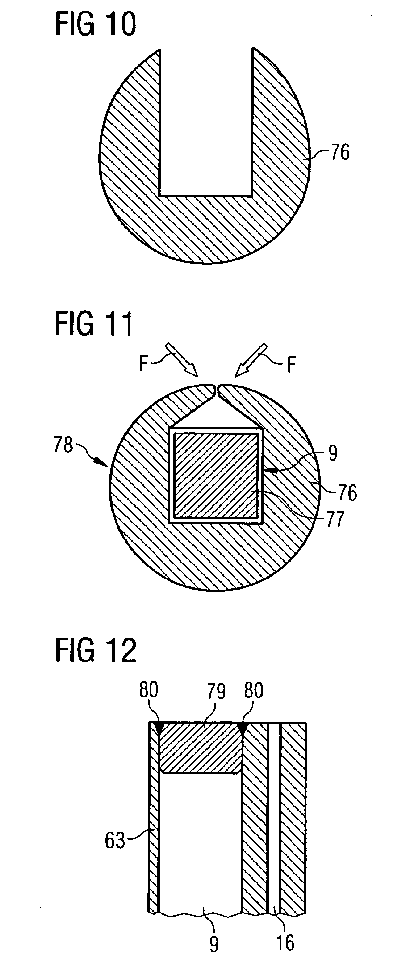

Figur 10 zeigt ein vorgefertigtes U-förmiges weiteres Profilstück 76, das beispielsweise aus einem Rundmaterial geformt ist.

Figur 11 zeigt einen Dorn 77 der in die Ausnehmung der U-Form des weiteren Profilstücks 76 eingelegt ist.

Anschließend werden die Schenkel der U-Form des weiteren Profilstücks 76 durch ein Rollverfahren um den Dorn 77 geformt. Dadurch werden die Schenkelenden aufeinander zubewegt. Der Dorn 77 wird entfernt und die Schenkelenden werden miteinander verbunden, vorzugsweise verschweißt. Somit wird eine vierte Hülse 78 mit einem Aktorraum erhalten. In dem dargestellten Beispiel weist der Dorn 77 einen quadratischen Querschnitt auf. Jedoch kann der Querschnitt des Dorns 77 auch andere Formen von n-eckig bis kreisförmig aufweisen. Abhängig von der gewählten Ausführungsform können die Schenkel zum Angleichen an die Kontur des Dorns 77 auch gehämmert oder geschmiedet werden.

Entsprechend der Ausbildungsform der Figur 9 können auch die in den Figuren 3, 5, 7 und 11 beschriebenen Hülsen 41, 54, 63, 78 zu einem Gehäuse 2 mit einer unteren und oberen Abdeckplatte 64, 65 montiert werden.

Figur 12 zeigt einen Teilquerschnitt durch eine weitere Ausführungsform eines Gehäuses, das die dritte Hülse 63 aufweist, in deren offenes oberes Ende ein Stopfen 79 eingesteckt ist, der über weitere Schweißnähte 80 mit der Hülse 63 verbunden ist. Zudem ist in die dritte Hülse 63 eine Kraftstoffbohrung 16 eingebracht. Auf diese Weise können auch die übrigen Hülsen verschlossen werden.

## Patentansprüche

1. Einspritzventil (1) mit einem Gehäuse (2), mit einer Einspritzdüse (5), mit einem piezoelektrischen Aktor (7), wobei die Einspritzdüse (5) am unteren Ende des Gehäuses (2) befestigt ist, wobei der Aktor (7) im Gehäuse (2) angeordnet ist, wobei das Gehäuse (2) eine an einem Ende offene Hülsenform (41, 54, 63) aufweist, wobei der Aktor (7) in Wirkverbindung mit einer Einspritznadel (19) steht, die in der Einspritzdüse (5) zur Steuerung einer Einspritzung vorgesehen ist,
wobei das Gehäuse (2) eine Hülse (41, 54, 63) aufweist, dass die Hülse (41, 54, 63) entlang einer Längsachse eine Verbindungsnaht (40, 52, 53, 62) aufweist, an der zwei aneinander angrenzende Längskanten (38, 39) der Hülse (41, 54, 63) miteinander verbunden sind, **dadurch gekennzeichnet, dass** die Hülse (41, 63, 78) aus einem geformten, insbesondere einem gewalzten oder stranggepressten Profilstück (37 ,44 ,55) gefertigt ist, dass durch das Formen eine Kontur (35, 45, 61) eines Aktorraums (9) in das Profilstück (37, 44, 55) eingebracht ist, wobei der Aktorraum (9) zur Aufnahme des Aktors (7) vorgesehen ist, und dass durch einen anschließenden Biegeprozess entlang einer Längsachse des Profilstückes (37, 44, 55) und einem Verbinden von zwei einander zugeordneten Längskanten (38, 39) des gebogenen Profilstückes (37, 44, 55) eine Hülse (41, 63, 78) hergestellt ist.

2. Einspritzventil nach Anspruch 1, **dadurch gekennzeichnet, dass** die Hülse (41, 54, 63) aus einer Platte (37) gebogen ist.

3. Einspritzventil nach Anspruch 1 oder 2, **dadurch gekennzeichnet, dass** die Hülse (54) aus einem im Querschnitt u-förmig geformten Profilstück (44) mit einer offenen Längsseite ausgebildet ist, dass die offene Längsseite mit einer Abdeckung (47) bedeckt ist, die mit zwei Randbereichen entlang der offenen Seite des Profilstücks (44) verbunden ist und ein Aktorraum (9) zwischen dem Profilstück (44) und der Abdeckung (47) ausgebildet ist.

4. Einspritzventil nach einem der Ansprüche 1 oder 2, **dadurch gekennzeichnet, dass** das Gehäuse (2) aus einer Hülse (63) mit einem U-Profil im Querschnitt gebildet ist, dass ein erster Schenkel (58) des U-Profil länger als ein zweiter Schenkel (56) ist, dass der längere Schenkel (58) entlang einer Längsachse umgebogen und auf eine Längskante des kürzeren Schenkel (56) gelegt ist, und dass die zwei Schenkel (56, 58) im Bereich der Längskante form- oder kraftschlüssig zusammen gehalten sind.

5. Einspritzventil nach einem der Ansprüche 1 bis 4, **dadurch gekennzeichnet, dass** das Gehäuse (2) eine untere Platte (65) aufweist, dass die untere Platte (65) mit einem unteren Ende der Hülse (63) form-/ oder kraftschlüssig verbunden ist, wobei die untere Platte quer zur Längsachse der Hülse (63) angeordnet ist und die Hülse (63) auf einer Oberseite der Platte aufgelegt ist, dass an einer Außenseite der unteren Platte (65) ein Gewinde (10) ausgebildet ist, an dem eine Spannmutter (6) verschraubt ist, wobei die Spannmutter (6) die Einspritzdüse (5, 17) gegen die untere Platte (65) vorspannt.

6. Einspritzventil nach einem der Ansprüche 1 bis 5, **dadurch gekennzeichnet, dass** das Gehäuse (2) eine obere, Platte (64) aufweist, die quer zur Hülse (63) angeordnet ist, dass die Hülse (63) mit einem oberen Ende an einer Unterseite der Platte (64) befestigt ist, dass um die Hülse (63) und die obere Platte (64) eine Spannhülse (8) gelegt ist, die mit einem unteren Randbereich gegen die Einspritzdüse (5, 17) abgestützt ist, und dass die Spannhülse (8) im oberen Endbereich eine Auflagefläche (12) für ein Spannmittel (13) aufweist.

7. Einspritzventil nach einem der Ansprüche 1 bis 6, **dadurch gekennzeichnet, dass** der Aktorraum (9) im Querschnitt eine abgerundete Viereckform aufweist.

8. Einspritzventil nach einem der Ansprüche 1 bis 7, **dadurch gekennzeichnet, dass** das Profilstück (37, 44, 55) aus einem Material gebildet ist, das einen Ausdehnungskoeffizienten entsprechend dem piezoelektrischen Aktor (7) aufweist.

9. Verfahren zum Herstellen eines Gehäuses (2) für ein Einspritzventil, wobei ein längliches Profilstück (37, 44, 55) aus einem formbaren Material erstellt wird, wobei entlang einer Längsachse eine Kontur (35, 45, 61) in das Profilstück (37, 44, 55) eingearbeitet wird, die eine Kontur eines Aktorraums (9) darstellt, wobei das Profilstück (37, 44, 55) zu einer Hülse (41, 54, 63) geformt wird, wobei die Kontur (35, 46, 61) den Aktorraum (9) begrenzt, wobei die Hülse (41, 54, 63, 78) zu einem Gehäuse (2) weiter verarbeitet wird, so dass ein Gehäuse (2) mit einem Aktorraum (9) zur Aufnahme eines piezoelektrischen Aktors (7) erhalten wird.

10. Verfahren nach Anspruch 9, **dadurch gekennzeichnet, dass** die Kontur (35, 45, 61) mit einem Walzverfahren in das Profilstück (37, 44, 55) eingebracht wird.

11. Verfahren nach Anspruch 9, **dadurch gekennzeichnet, dass** das Profilstück (37, 44, 55) mit der Kontur (35, 45, 61) mit einem Strangpressverfahren hergestellt wird.

12. Verfahren nach einem der Ansprüche 9 bis 11, **dadurch gekennzeichnet, dass** eine Abdeckung (47) aus dem gleichen Material wie das Profilstück (44) gefertigt wird, und dass die Abdeckung (47) auf zwei entlang der Langsachse des Profilstück (44) verlaufende Randbereiche aufgelegt und mit den Randbereichen verbunden wird.

13. Verfahren nach einem der Ansprüche 9 bis 11, **dadurch gekennzeichnet, dass** die Hülse (63) aus einem Profilstück (55) mit einem U-Profil im Querschnitt gebildet wird, dass ein erster Schenkel (58) des U-Profils länger als ein zweiter Schenkel (56) ist, dass der längere Schenkel (58) entlang einer Längsachse (75) umgebogen und auf eine Längskante des kürzeren Schenkel (56) gelegt wird, und dass die zwei Schenkel (56, 58) im Bereich der Längskanten form- oder kraftschlüssig zusammen gehalten werden.

14. Verfahren nach einem der Ansprüche 9 bis 13, **dadurch gekennzeichnet, dass** die Hülse (41, 54, 63, 78) mit einer unteren Abdeckplatte (65) verbunden wird, die im wesentlichen quer zur Längsachse der Hülse (41, 54, 63, 78) angeordnet ist, dass gegen die untere Abdeckplatte (65) eine Einspritzdüse (5) mit einer Spannmutter (6) gespannt wird, wobei die Spannmutter mit der unteren Abdeckplatte (65) verbunden wird.

15. Verfahren nach einem der Ansprüche 9 bis 14, **dadurch gekennzeichnet, dass** die Hülse (41, 54, 63, 78) mit einer oberen Abdeckplatte (64) verbunden wird, die im wesentlichen quer zur Längsachse der Hülse (41, 54, 63, 78) angeordnet wird, dass um die obere Abdeckplatte (64) eine Spannhülse (8) geschoben wird, wobei die Spannhülse (8) auf der Höhe der oberen Abdeckplatte (64) eine Auflagefläche (12) zur Auflage eines Spannmittels (13) aufweist, und dass die Spannhülse (8) in einem unteren Bereich gegen die Einspritzdüse (5) abgestützt wird.

16. Verfahren nach Anspruch 9, **dadurch gekennzeichnet, dass** die Hülse (78) mit einem vorgeformten Profilstück (76) hergestellt wird, das an einen Dorn (77) angelegt wird und um den Dorn (77) geformt wird, wobei der Dorn (77) anschließend entfernt wird und eine Hülse (78) mit einem Aktorraum (9) erhalten wird.

## Claims

1. Injection valve (1) with a housing (2), with an injection nozzle (5), with a piezoelectric actuator (7), with the injection nozzle (5) being attached to the lower end of the housing (2), with the actuator (7) being arranged in the housing (2), with the housing (2) having the form of a sleeve open at one end (41, 54, 63), with the actuator (7) being effectively connected to the injection needle (19) which is provided in the injection nozzle (5) for controlling an injection,
with the housing (2) having a sleeve (41, 54, 63), that the sleeve (41, 54, 63) features a connecting seam (40, 52, 53, 62) along a longitudinal axis at which the two adjoining longitudinal edges (38, 39) of the sleeve (41, 54, 63) are connected to each other, **characterized in that** the sleeve (41, 63, 78) is made of a formed, especially a rolled or extruded profile section (37 ,44 ,55), that the forming inserts a contour (35, 45, 61) of an actuator space (9) into the profile section (37, 44, 55), with the actuator space (9) being provided to accommodate the actuator (7) and that through a subsequent bending process along a longitudinal axis of the profile section (37, 44, 55) and a joining of two adjacent assigned longitudinal edges (38, 39) of the bent profile section (37, 44, 55) a sleeve (41, 63, 78) is produced.

2. Injection valve according to claim 1, **characterised in that** the sleeve (41, 54, 63) is bent from a plate (37).

3. Injection valve according to claim 1 or 2, **characterised in that** the sleeve (54) is embodied from a formed profile section (44) with a U-shaped cross section with an open longitudinal side, that the open longitudinal side is covered by a cover (47) which is connected to two edge areas along the open side of the profile section (44) and an actuator space (9) is embodied between the profile section (44) and the cover (47).

4. Injection valve according to one of the claims 1 or 2, **characterised in that** the housing (2) is formed from a sleeve (63) with a U-profile in cross-section, that a first leg (58) of the U-profile is longer than a second leg (56), that the longer leg (58) is bent along a longitudinal axis and is laid onto a longitudinal edge of the shorter leg (56) and that the two legs (56, 58) are held together in the area of the longitudinal edge by a positive or non-positive fit.

5. Injection valve according to one of the claims 1 to 4, **characterised in that** the housing (2) has a lower plate (65), that the lower plate (65) is connected by a positive fit and/or non-positive fit to the lower end the sleeve (63), with the lower plate being arranged transverse to the longitudinal axis of the sleeve (63) and the sleeve (63) being laid on an upper side of the plate, that a thread (10) is embodied on the outside of the lower plate (65) onto which a clamping nut (6) is screwed, with the clamping nut (6) clamping the injection nozzle (5, 17) against the lower plate (65).

6. Injection valve according to one of the claims 1 to 5, **characterised in that** the housing (2) has an upper plate (64) which is arranged transverse to the sleeve (63), that the sleeve (63) is attached with its upper end to the underside of the plate (64), that a clamping collar (8) is placed around the sleeve (63) and the upper plate (64) which is supported by a lower edge area against the injection nozzle (5, 17) and that the clamping collar (8) has a support surface (12) for a clamping means (13) in its upper end area.

7. Injection valve according one of the claims 1 to 6, **characterised in that** the actuator space (9) has a rounded rectangular shape.

8. Injection valve according to one of the claims 1 to 7, **characterised in that** the profile section (37, 44, 55) is formed from a material which has a coefficient of expansion corresponding to that of the piezoelectric actuator (7).

9. Method for manufacturing a housing (2) for a injection valve, with a longitudinal profile section (37, 44, 55) being created from a formable material, with a contour (35, 45, 61) being made in the profile section (37, 44, 55) along a longitudinal axis which represents one contour of an actuator space (9), with the profile section (37, 44, 55) being formed into a sleeve (41, 54, 63), with the contour (35, 46, 61) delimiting the actuator space (9), with the sleeve (41, 54, 63, 78) being further worked to form a housing (2), so that a housing (2) with an actuator space (9) to accommodate a piezoelectric actuator (7) is obtained.

10. Method according to claim 9, **characterised in that** the contour (35, 45, 61) is incorporated into the profile section (37, 44, 55) using a rolling method.

11. Method according to claim 9, **characterised in that** the profile section (37, 44, 55) with the contour (35, 45, 61) is manufactured using an extrusion method.

12. Method according to one of the claims 9 to 11, **characterised in that** a cover (47) is made from the same material as the profile section (44), and that the cover (47) is laid onto two edge areas running along the longitudinal axis of the profile section (44) and joined to the edge areas.

13. Method according to one of the claims 1 to 11, **characterised in that** the sleeve (63) is formed from a profile section (55) with a U-profile in the cross-section, that a first arm (58) of the U-profile is longer than a second arm (56), that the longer arm (58) is bent around along a longitudinal axis (75) and laid onto on longitudinal edge of the shorter arm (56), and that the two arms (56, 58) are held together in the area of the longitudinal edges by a positive or non-positive fit.

14. Method according to one of the claims 1 to 13, **characterised in that** the sleeve (41, 54, 63, 78) is connected to a lower cover plate (65) which is essentially arranged transverse to the longitudinal axis of the sleeve (41, 54, 63, 78), that an injection nozzle (5) is clamped against the lower cover plate (65) with a clamping nut (6), with the clamping nut being connected to the lower cover plate (65).

15. Method according to one of the claims 1 to 14, **characterised in that** the sleeve (41, 54, 63, 78) is connected to an upper (64) cover plate which is essentially arranged transverse to the longitudinal axis of the sleeve (41, 54, 63, 78), that a clamping sleeve (8) is pushed around the upper cover plate (64), with the clamping sleeve (8) having a surface (12) at the height of the upper cover plate (64) for accommodating a clamping means (13), and that the clamping sleeve (8) is supported in a lower area against the injection nozzle (5).

16. Method according to claim 9, **characterised in that** the sleeve (78) is manufactured with a pre-formed profile section (76), which is placed onto a mandrel (77) and formed around the mandrel (77), with the mandrel (77) subsequently being removed and a sleeve (78) with an actuator space (9) obtained.

## Revendications

1. Soupape d'injection (1) comportant un boîtier (2), une buse d'injection (5), un actionneur piézoélectrique (7), la buse d'injection (5) étant fixée contre l'extrémité inférieure du boîtier (2), l'actionneur (7) étant agencé dans le boîtier (2), le boîtier (2) ayant une forme de manchon (41, 54, 63) ouvert à une extrémité, l'actionneur (7) étant en liaison active avec une aiguille d'injecteur (19) qui est prévue dans la buse d'injection (5) pour commander une injection, le boîtier (2) comportant un manchon (41, 54, 63), le manchon (41, 54, 63) étant muni le long d'un axe longitudinal d'un cordon d'assemblage (40, 52, 53, 62), au niveau duquel deux arêtes longitudinales (38, 39) face à face du manchon (41, 54, 63) sont assemblées l'une à l'autre, **caractérisée en ce que** le manchon (41, 63, 78) est réalisé dans une pièce profilée (37, 44, 55) façonnée, en particulier laminée ou extrudée, **en ce qu'**un contour (35, 45, 61) d'un logement d'actionneur (9) est ménagé par le formage dans la pièce profilée (37, 44, 55), le logement d'actionneur (9) étant prévu pour recevoir l'actionneur (7), et **en ce qu'**un manchon (41, 54, 63) est réalisé par un processus de pliage consécutif le long d'un axe longitudinal de la pièce profilée (37, 44, 55) et par un assemblage de deux arêtes longitudinales (38, 39) face à face de la pièce profilée (37, 44, 55) courbe.

2. Soupape d'injection selon la revendication 1, **caractérisée en ce que** le manchon (41, 54, 63) est courbé à partir d'une plaque (37).

3. Soupape d'injection selon la revendication 1 ou 2, **caractérisée en ce que** le manchon (54) est réalisé à partir d'une pièce profilée (44) avec une section en forme de U et un côté longitudinal ouvert, **en ce que** le côté longitudinal ouvert est fermé par une partie de recouvrement (47), qui est assemblée à deux zones de bordure le long du côté ouvert de la pièce profilée (44) et un logement d'actionneur (9) est formé entre la pièce profilée (44) et la partie de recouvrement (47).

4. Soupape d'injection selon la revendication 1 ou 2, **caractérisée en ce que** le boîtier (2) est formé à partir d'un manchon (63) avec une section en forme de U, **en ce qu'**une première branche (58) du profil en U est plus longue qu'une deuxième branche (56), **en ce que** la branche plus longue (58) est pliée le long d'un axe longitudinal et est posée sur une arête longitudinale de la branche plus courte (56), et **en ce que** les deux branches (56, 58) sont maintenues ensemble par conjugaison de forme ou de force dans la zone de l'arête longitudinale.

5. Soupape d'injection selon l'une quelconque des revendications 1 à 4, **caractérisée en ce que** le boîtier (2) comporte une plaque inférieure (65), **en ce que** la plaque inférieure (65) est assemblée par conjugaison de forme ou de force à une extrémité inférieure du manchon (63), ladite plaque inférieure étant orientée perpendiculairement à l'axe longitudinal du manchon (63) et le manchon (63) étant posé sur une face supérieure de la plaque, **en ce que** sur une face extérieure de la plaque inférieure (65) est réalisé un filetage extérieur (10), sur lequel est vissé un écrou de serrage (6), l'écrou de serrage (6) étant destiné à précontraindre la buse d'injection (5, 17) contre la plaque inférieure (65).

6. Soupape d'injection selon l'une quelconque des revendications 1 à 5, **caractérisée en ce que** le boîtier (2) comporte une plaque supérieure (64), qui est disposée perpendiculairement au manchon (63), **en ce que** le manchon (63) est fixé par une extrémité supérieure contre une face inférieure de la plaque (64), **en ce qu'**autour du manchon (63) et de la plaque supérieure (64) est posé un manchon de serrage (8), qui prend appui avec un bord inférieur contre la buse d'injection (5, 17), et **en ce que** le manchon de serrage (8) comporte dans la zone d'extrémité supérieure une surface d'appui (12) pour un moyen de serrage (13).

7. Soupape d'injection selon l'une quelconque des revendications 1 à 6, **caractérisée en ce que** le logement d'actionneur (9) a une section en forme de rectangle aux angles arrondis.

8. Soupape d'injection selon l'une quelconque des revendications 1 à 7, **caractérisée en ce que** la pièce profilée (37, 44, 55) est réalisée dans un matériau dont le coefficient de dilatation thermique correspond à celui de l'actionneur piézoélectrique (7).

9. Procédé pour la fabrication d'un boîtier (2) pour une soupape d'injection, dans lequel une pièce profilée (37, 44, 55) allongée est réalisée à partir d'un matériau façonnable, un contour (35, 45, 61) étant ménagé dans la pièce profilée (37, 44, 55) le long d'un axe longitudinal pour constituer un contour d'un logement d'actionneur (9), la pièce profilée (37, 44, 55) étant formée pour obtenir un manchon (41, 54, 63), le contour (35, 46, 61) délimitant le logement d'actionneur (9), le manchon (41, 54, 63, 78) étant davantage façonné pour former un boîtier (2) de manière à obtenir un boîtier (2) avec un logement d'actionneur (9) destiné à recevoir un actionneur piézoélectrique (7).

10. Procédé selon la revendication 9, **caractérisé en ce que** le contour (35, 45, 61) est aménagé dans la pièce profilée (37, 44, 55) par un procédé de laminage.

11. Procédé selon la revendication 9, **caractérisé en ce que** la pièce profilée (37, 44, 55) est réalisée avec un contour (35, 45, 61) au moyen d'un procédé d'extrusion.

12. Procédé selon l'une quelconque des revendications 9 à 11, **caractérisé en ce qu'**une partie de recouvrement (47) est réalisée dans le même matériau que la pièce profilée (44), et ce que la partie de recouvrement (47) est posée sur deux zones de bordure orientées le long de l'axe longitudinal de la pièce profilée (44) et est assemblée aux deux zones de bordure.

13. Procédé selon l'une quelconque des revendications 9 à 11, **caractérisé en ce que** le manchon (63) est formé à partir d'une pièce profilée (55) avec une section à profil en U, **en ce qu'**une première branche (58) du profil en U est plus longue qu'une deuxième branche (56), **en ce que** la branche plus longue (58) est pliée le long d'un axe longitudinal et est posée sur une arête longitudinale de la branche plus courte (56), et **en ce que** les deux branches (56, 58) sont maintenues ensemble par conjugaison de forme ou de force dans la zone de l'arête longitudinale.

14. Procédé selon l'une quelconque des revendications 9 à 13, **caractérisé en ce que** le manchon (41, 54, 63, 78) est assemblé à une plaque de recouvrement inférieure (65), qui est sensiblement perpendiculaire à l'axe longitudinal du manchon (41, 54, 63, 78), **en ce qu'**une buse d'injection (5) est serrée avec un écrou de serrage (6) contre la plaque de recouvrement inférieure (65), l'écrou de serrage étant assemblé à la plaque de recouvrement inférieure (65).

15. Procédé selon l'une quelconque des revendications 9 à 14, **caractérisé en ce que** le manchon (41, 54, 63, 78) est assemblé à une plaque de recouvrement supérieure (64), qui est sensiblement perpendiculaire au manchon (41, 54, 63, 78), **en ce qu'**un manchon de serrage (8) est posé autour de la plaque de recouvrement supérieure (64), le manchon de serrage (8) comportant, à la hauteur de la plaque de recouvrement supérieure (64), une surface d'appui (12) destinée à former un appui pour un moyen de serrage (13), et **en ce que** le manchon de serrage (8) est en appui dans une zone inférieure contre la buse d'injection (5).

16. Procédé selon la revendication 9, **caractérisé en ce que** le manchon (78) est réalisé avec une pièce profilée (76) préformée, qui est posée sur un mandrin (77) et est formée autour du mandrin (77), le mandrin (77) étant ensuite retiré et un manchon (78) avec un logement d'actionneur (9) étant obtenu.
